# FASCICULE DE BREVET EUROPEEN

(11) **EP 4 362 093 B1**
(45) Date de publication et mention de la délivrance du brevet: **11.02.2026**
(21) Numéro de dépôt: 23204952.8
(22) Date de dépôt: 20.10.2023
(51) Int. Cl.: H10H 29/20

(54) **DISPOSITIF EMETTEUR ET RECEPTEUR DE LUMIERE**
LICHTEMITTIERENDE VORRICHTUNG UND LICHTEMPFÄNGER
LIGHT EMITTING AND RECEIVING DEVICE

(30) Priorité: 27.10.2022 FR 2211189
(43) Date de publication de la demande: 01.05.2024
(73) Titulaire: Commissariat à l'Energie Atomique et aux Energies Alternatives, 75015 Paris (FR)
(72) Inventeur: DUPONT, Florian, 38054 Grenoble Cedex 09 (FR)
(74) Mandataire: Cabinet Beaumont

(56) Documents cités:
- FR-A1- 3 119 931
- US-A1- 2012 138 962
- US-A1- 2017 084 775
- US-A1- 2017 244 003
- US-A1- 2018 277 705
- US-A1- 2019 288 686
- US-A1- 2022 247 366

## Description

### Domaine technique

La présente description concerne le domaine des dispositifs optoélectroniques de façon générale. Elle vise plus particulièrement un dispositif émetteur et récepteur de lumière.

### Technique antérieure

On a déjà proposé un dispositif d'affichage émissif comportant une matrice de diodes électroluminescentes (LED), et un circuit de contrôle permettant de commander individuellement les LED pour afficher des images.

Pour certaines applications, le dispositif peut en outre comprendre une source lumineuse infrarouge et un récepteur infrarouge, commandés de façon coordonnée pour mesurer des informations de distance à une scène ou à un objet, aussi appelées informations de profondeur, par exemple par mesure de temps de vol ou par analyse de déformations d'un faisceau lumineux structuré. Ceci permet par exemple de réaliser un dispositif d'affichage interactif dans lequel les images affichées peuvent être adaptées en fonction des informations de profondeur mesurées au moyen du dispositif d'émission/réception infrarouge.

Pour certaine applications, il serait souhaitable de pourvoir intégrer la source infrarouge et le récepteur infrarouge de façon distribuée au sein de la matrice de diodes électroluminescentes du dispositif d'affichage.

US 2018/277705 A1 divulgue un dispositif optoélectronique comportant une diode électroluminescente comportant une première couche active, une première électrode en contact avec la face inférieure de la première couche active, et une deuxième électrode en contact avec la face supérieure de la première couche active, et une diode de détection de lumière positionnée sur la diode électroluminescente, et comportant une deuxième couche active, une troisième électrode en contact avec la face inférieure de la deuxième couche active, et une quatrième électrode en contact avec la face supérieure de la deuxième couche active.

### Résumé de l'invention

L'invention est définie par la revendication 1. Un mode de réalisation prévoit un dispositif émetteur et récepteur de lumière comportant :
- une diode électroluminescente comportant une première couche active, une première électrode en contact avec la face inférieure de la première couche active, et une deuxième électrode en contact avec la face supérieure de la première couche active ; et
- sur la diode électroluminescente, un élément de conversion et de détection de lumière comportant une deuxième couche active, une troisième électrode en contact avec la face inférieure de la deuxième couche active, et une quatrième électrode en contact avec la face supérieure de la deuxième couche active, le dispositif comprend en outre un circuit électronique de contrôle configuré pour, lors d'une phase d'émission, appliquer un courant dans la première couche active par l'intermédiaire des première et deuxième électrodes, et maintenir les troisième et quatrième électrodes en circuit ouvert, ou, lors d'une phase de réception, maintenir les première et deuxième électrodes en circuit ouvert ou en court-circuit et mesurer, par l'intermédiaire des troisième et quatrième électrodes, un signal électrique représentatif d'un rayonnement lumineux absorbé par la deuxième couche active.

Selon un mode de réalisation, la deuxième couche active comprend un matériau photoluminescent adapté, lors de la phase d'émission, à absorber des photons dans la gamme de longueurs d'ondes d'émission de la diode électroluminescente, et, en réponse à réémettre des photons dans une autre gamme de longueur d'ondes, et, lors de la phase de réception, à générer un signal électrique représentatif d'un rayonnement lumineux absorbé.

Selon un mode de réalisation, la diode électroluminescente est adaptée à émettre de la lumière visible, et dans lequel la deuxième couche active est adaptée à émettre un rayonnement infrarouge.

Selon un mode de réalisation, la deuxième couche active comprend une couche en un matériau pérovskite.

Selon un mode de réalisation, ladite couche en un matériau pérovskite est en un matériau pérovskite inorganique.

Selon un mode de réalisation, ladite couche en un matériau pérovskite est en CsSnI3.

Selon un mode de réalisation, les deuxième et troisième électrodes sont transparentes dans la gamme de longueurs d'ondes d'émission de la diode électroluminescente, et dans lequel la quatrième électrode est transparente dans la gamme de longueur d'onde d'émission de la deuxième couche active.

Selon un mode de réalisation, les deuxième et troisième électrodes sont isolées électriquement l'une de l'autre par une couche de passivation transparente dans la gamme de longueurs d'ondes d'émission de la diode électroluminescente.

Selon un mode de réalisation, le dispositif comprend en outre, sur la face supérieure de l'élément de conversion et de détection de lumière, un filtre optique adapté à laisser passer les rayonnements lumineux dans la gamme de longueurs d'ondes d'émission de la deuxième couche active et à bloquer les rayonnements lumineux dans la gamme de longueurs d'onde d'émission de la diode électroluminescente.

Un autre mode de réalisation prévoit une puce élémentaire de dispositif optoélectronique comprenant un dispositif émetteur et récepteur de lumière tel que défini ci-dessus.

Selon un mode de réalisation, la puce comporte en outre une ou plusieurs cellules émissives comportant chacune une diode électroluminescente .

Un autre mode de réalisation prévoit un dispositif optoélectronique comportant une pluralité de puces élémentaires telles que définies ci-dessus fixées et connectées électriquement à une même dalle d'interconnexion.

Procédé de fabrication d'un dispositif tel que défini ci-dessus, dans lequel le matériau pérovskite est déposé par dépôt laser pulsé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe schématique d'un exemple d'un dispositif émetteur et récepteur de lumière selon un mode de réalisation ;
la figure 2 est une vue en coupe illustrant plus en détail un exemple de réalisation du dispositif de la figure 1 ;
la figure 3 est une vue en coupe illustrant plus en détail un autre exemple de réalisation du dispositif de la figure 1 ;
la figure 4 est une vue en coupe illustrant de façon schématique un exemple d'un pixel d'un dispositif d'affichage interactif ; et
la figure 5 est une vue en coupe illustrant de façon schématique un autre exemple d'un pixel d'un dispositif d'affichage interactif.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits électroniques de contrôle des dispositifs émetteurs et/ou récepteurs de lumière décrits n'ont pas été détaillés, les modes de réalisation décrits étant compatibles avec les circuits de contrôle usuels de dispositifs émetteurs et/ou récepteurs de lumière, ou la réalisation de ces circuits étant à la portée de la personne du métier à partir des indications de la présente description. En outre, les procédés de fabrication des dispositifs émetteurs et/ou récepteurs de lumière décrits n'ont pas été détaillés, les modes de réalisation décrits étant compatibles avec les procédés usuels de fabrication de dispositifs émetteurs et/ou récepteurs de lumière, ou la mise en oeuvre de ces procédés étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect des modes de réalisation décrits, on prévoit un dispositif émetteur et récepteur de lumière comprenant une source lumineuse et un élément de conversion de longueur d'onde superposé à la source lumineuse. En émission, la source lumineuse est activée et l'élément de conversion de longueur d'onde convertit la lumière émise par la source lumineuse vers une autre gamme de longueurs d'onde appelée gamme de longueurs d'onde d'émission de l'élément de conversion. En réception, la source lumineuse est désactivée, et l'élément de conversion est connecté électriquement, par des électrodes transparentes, à un circuit de lecture. L'élément de conversion est alors utilisé comme détecteur photosensible. Plus particulièrement, le circuit de lecture permet de lire un signal électrique représentatif d'une intensité lumineuse reçue par l'élément de conversion dans sa gamme de longueurs d'onde d'absorption.

Un tel dispositif peut ainsi être utilisé au choix comme émetteur ou comme récepteur de lumière, dans une gamme de longueurs d'onde déterminée par le choix de l'élément de conversion. Ceci permet, d'intégrer, selon des agencements divers et variés, éventuellement reconfigurables, des sources et détecteurs lumineux, par exemple infrarouges, dans de nombreux dispositifs, par exemple des dispositifs d'affichage interactifs. Le coût de production se trouve réduit du fait de l'utilisation de composants identiques pour la fonction d'émission et pour la fonction de réception (économie d'échelle).

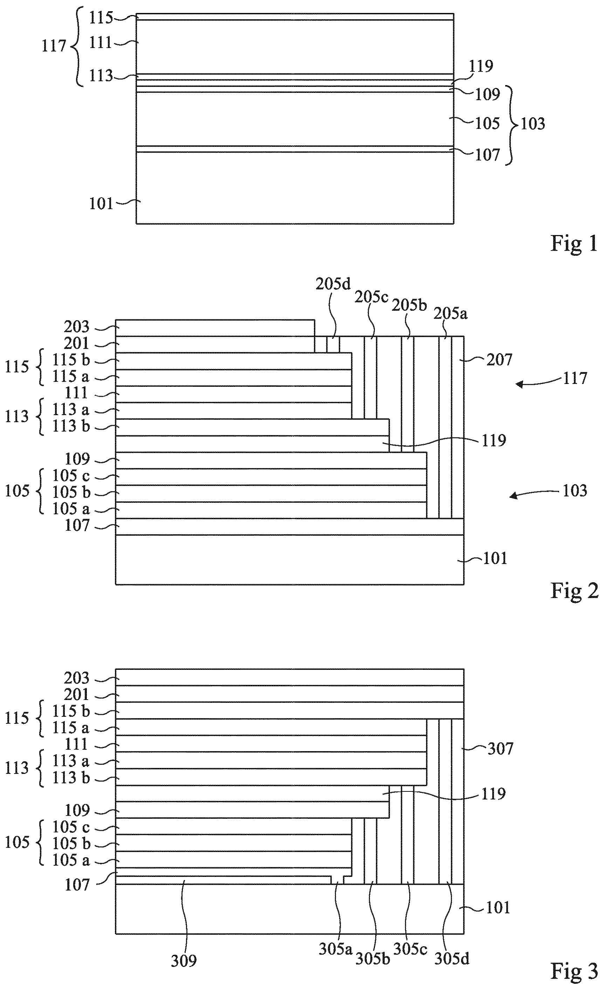

La figure 1 est une vue en coupe schématique d'un exemple d'un dispositif émetteur et récepteur de lumière selon un mode de réalisation.

Le dispositif de la figure 1 comprend un substrat 101, par exemple en silicium, en verre, en saphir ou en tout autre matériau adapté.

Le dispositif de la figure 1 comprend en outre, du côté de la face supérieure du substrat 101, une LED 103 comprenant une couche active 105, une électrode inférieure 107 et une électrode supérieure 109. L'électrode inférieure 107 est en contact, par sa face supérieure, avec la face inférieure de la couche active 105, et l'électrode supérieure 109 est en contact, par sa face inférieure, avec la face supérieure de la couche active 105. Dans cet exemple, l'électrode inférieure 107 est en contact, par sa face inférieure, avec la face supérieure du substrat 101.

La couche active 105 est par exemple une couche semiconductrice inorganique ou un empilement de couches semiconductrices inorganiques, par exemple à base d'un ou plusieurs matériaux semiconducteurs de type III-V, par exemple à base de nitrure de gallium. A titre d'exemple, la LED 103 est adaptée à émettre majoritairement de la lumière bleue, par exemple dans une gamme de longueurs d'onde comprise entre 380 et 500 nm.

Le dispositif de la figure 1 comprend en outre, du côté de la face supérieure de la LED 103, un élément de conversion de longueur d'onde photoluminescent 111. L'élément 111 est une couche d'un matériau semiconducteur adapté à absorber des photons dans une gamme de longueurs d'onde d'émission de la LED 103, et à réémettre des photons dans une autre gamme de longueurs d'onde appelée gamme de longueurs d'onde d'émission de l'élément de conversion, par exemple une gamme de longueurs d'onde infrarouge, par exemple comprise entre 780 nm et 3 µm, par exemple entre 800 nm et 1,5 µm.

Le dispositif de la figure 1 comprend en outre une électrode 113 disposée du côté de la face inférieure de la couche de conversion 111 et une électrode supérieure 115 disposée du côté de la face supérieure de la couche de conversion 111. L'électrode 113 est en contact, par sa face supérieure, avec la face inférieure de la couche de conversion 111, et l'électrode 115 est en contact, par sa face inférieure, avec la face supérieure de la couche de conversion 111.

Les électrodes 113 et 115 et la couche de conversion 111 définissent un photodétecteur 117 adapté à convertir en un signal électrique un signal lumineux reçu dans une gamme de longueurs d'onde caractéristique de la couche de conversion 111.

Dans l'exemple de la figure 1, l'électrode inférieure 113 du photodétecteur 117 est isolée électriquement de l'électrode supérieure 109 de la LED 103 par une couche isolante 119. Dans l'exemple représenté, la couche isolante 119 est en contact, par sa face inférieure, avec la face supérieure de l'électrode 109, et, par sa face supérieure, avec la face inférieure de l'électrode 113.

En phase d'émission, la LED 103 est activée. Pour cela, un courant est injecté dans sa couche active 105 par l'intermédiaire des électrodes 107 et 109. Il en résulte l'émission de photons par la couche active 105 de la LED.

Les photons émis par la LED 103 sont absorbés par la couche de conversion 111 qui émet en réponse des photons dans la gamme de longueurs d'onde d'émission de la couche 111.

Pendant la phase d'émission, les électrodes 113 et 115 sont maintenues en circuit ouvert, non polarisées. Par exemple, les électrodes 113 et 115 sont laissées flottantes. Ceci permet de ne pas évacuer les charges électriques photo-générées dans la couche 111 lors de l'absorption des photons émis par la LED 103, et permet ainsi la réémissions de photons par la couche 111, dans sa gamme de longueurs d'onde d'émission.

En phase de réception, la LED 103 est désactivée, c'est à dire qu'aucun courant n'est injecté dans sa couche active 105 qui n'émet alors pas de photons. A titre d'exemple, les électrodes 107 et 109 de la LED sont laissées en circuit ouvert ou mises en court-circuit.

Les électrodes 113 et 115 du photodétecteur sont quant à elles connectées à un circuit de lecture adapté à mesurer un signal électrique représentatif d'un rayonnement lumineux absorbé par la couche de conversion 111 dans sa gamme de longueurs d'onde d'absorption. A titre d'exemple, le circuit de lecture est adapté à mesurer un photo-courant circulant entre les électrodes 113 et 115 sous l'effet du rayonnement lumineux incident.

La réalisation du circuit électronique de contrôle du dispositif, adapté, en phase d'émission, à activer la LED pour émettre de la lumière et à maintenir les électrodes 113 et 115 du photodétecteur 117 en circuit ouvert, et, en phase de réception, à désactiver la LED et à mesurer, par l'intermédiaire des électrodes 113 et 115, un signal électrique représentatif du rayonnement lumineux incident, n'a pas été détaillé, la réalisation d'un tel circuit étant à la portée de la personne du métier à partir des indications fonctionnelles de la présente description.

Dans l'exemple de la figure 1, le dispositif est adapté à émettre et recevoir de la lumière par sa face supérieure.

L'électrode inférieure 107 comprend de préférence au moins une couche réfléchissante dans la gamme de longueurs d'onde d'émission de la LED 103, par exemple une couche métallique, par exemple en aluminium.

L'électrode supérieure 109 est de préférence transparente à la longueur d'onde d'émission de la LED 103. A titre d'exemple, l'électrode supérieure 109 est en un oxyde conducteur transparent, par exemple en oxyde d'indium étain (ITO) .

La couche électriquement isolante 119 est de préférence transparente dans la gamme de longueurs d'onde d'émission de la LED 103. A titre d'exemple, la couche 119 est oxyde de silicium (SiO₂).

L'électrode inférieure 113 du photodétecteur 117 est de préférence transparente dans la gamme de longueurs d'onde d'émission de la LED 103. A titre d'exemple, l'électrode 113 comprend un empilement d'une ou plusieurs couches d'un ou plusieurs oxydes conducteurs transparents.

L'électrode supérieure 115 du photodétecteur 117 est de préférence transparente dans la gamme de longueurs d'onde d'émission de la couche de conversion 111. A titre d'exemple, l'électrode 115 comprend un empilement d'une ou plusieurs couches d'un ou plusieurs oxydes conducteurs transparents.

De préférence, la couche de conversion photoluminescente 111 est en un matériau à structure pérovskite aussi appelé matériau pérovskite.

Un avantage est que les matériaux pérovskites, présentent une efficacité quantique interne élevée, pouvant aller jusqu'à 100%.

Un autre avantage est que les matériaux pérovskites présentent un coefficient d'absorption élevé. Ainsi, la fonction de conversion lumineuse et la fonction de photo-détection peuvent être assurées efficacement par une couche relativement mince, par exemple une couche d'épaisseur inférieure à 1 µm, par exemple comprise dans la plage allant de 200 à 500 nm.

Un autre avantage est que les matériaux pérovskites peuvent être déposés à des températures relativement basses, par exemple inférieures à 400°C, ce qui permet notamment leur dépôt au-dessus d'un circuit intégré de type CMOS (de l'anglais "Complementary Metal Oxide Semiconductor" - métal oxyde semiconducteur complémentaire).

La couche 111 est par exemple déposée par dépôt PLD (de l'anglais "Pulsed Laser Deposition" - dépôt laser pulsé). Le dépôt PLD consiste à pulvériser ou ablater une cible du matériau pérovskite au moyen d'un laser pulsé, de manière à transférer le matériau dans un plasma, puis, via le plasma, sur le substrat de destination. Un avantage du dépôt PLD est qu'il permet de déposer des matériaux de composition complexe tels que les matériaux pérovskites avec une bonne qualité cristalline, et ce à une température relativement basse, par exemple inférieure à 400°C. Un autre avantage de la PLD est la possibilité de déposer ces matériaux sans endommager le substrat de destination. A titre de variante, la couche 111 peut être déposée par toute autre méthode de dépôt adaptée. La couche 111 est par exemple déposée par dépôt en voie liquide, par exemple par dépôt sol-gel, par revêtement au moyen d'une lame (« blade coating » en anglais), par dépôt par filière à fente (« slot-die coating » en anglais), par revêtement par spray (« spray coating » en anglais), ou par impression jet d'encre (« inkjet printing » en anglais). A titre de variante, la couche 111 est déposée par dépôt en voie solide, par exemple par dépôt physique en phase vapeur, par exemple par évaporation, co-évaporation, pulvérisation ou co-pulvérisation.

Un ou plusieurs recuits peuvent être mis en oeuvre pour obtenir la phase cristalline souhaitée du matériau périovskite.

Un autre avantage est que les matériaux pérovskites présentent une grande tolérance aux défauts de structure cristalline. Ainsi, la fonction de conversion lumineuse et la fonction de photo-détection peuvent être assurées efficacement par une couche polycristalline d'épaisseur relativement faible.

Du fait des faibles épaisseurs requises pour assurer la fonction de conversion lumineuse et la fonction de photo-détection, les couches de matériaux pérovskites peuvent être gravées facilement, ce qui permet de réaliser des éléments de conversion et de détection présentant de très petites dimensions latérales.

Il en résulte que les matériaux pérovskites sont particulièrement avantageux pour la réalisation de dispositifs d'émission et de réception lumineuse dans des pixels de petites dimensions, par exemple pour la réalisation d'écrans d'affichage d'images couleur présentant un pas inter-pixel inférieur à 100 µm, par exemple inférieur à 20 µm, voire inférieur à 5 µm.

Le matériau pérovskite utilisé est par exemple un matériau inorganique. A titre de variante, un matériau pérovskite organique peut être utilisé.

A titre d'exemple, on pourra utiliser un matériau pérovskite à base de césium, d'étain et d'iode, par exemple du CsSnI₃ pour émettre et recevoir de la lumière infrarouge. Plus généralement, tout matériau pérovskite présentant une bande interdite (bandgap en anglais) à la longueur d'onde de fonctionnement souhaitée peut être utilisé.

De façon générale, on utilisera de préférence des matériaux pérovskites dits halogènes, c'est-à-dire de type ABX₃, où :
- A est un élément inorganique (on parle alors de matériau pérovskite halogène inorganique), par exemple du césium (Cs), du rubidium (Rb), du phosphore (K) ou du lithium (Li), ou un élément organique (on parle alors de matériau pérovskite halogène organique), par exemple du formadiminium, aussi appelé FA, de formule chimique CN₂H₅₊, ou du Methylammonium, aussi appelé MA, de formule chimique CH₃NH₃₊, ou une combinaison de ces éléments,
- B est par exemple du plomb (Pb), de l'étain (Sn) ou du germanium (Ge), ou une combinaison de ces éléments, et
- X est un halogène, par exemple le brome (Br), le chlore (Cl), l'iode (I) ou une combinaison d'halogènes.

Les modes de réalisation décrits ne se limitent toutefois pas à ces structures particulières de matériaux pérovskites.

A titre de variante, des structures halogénées de type, ABX₃ ou A₂BX₄ ou A₃BX₅ ou A₄BX₆ peuvent être utilisées, où B est compris dans la liste comprenant le plomb (Pb), l'étain (Sn), le germanium (Ge), éventuellement le cuivre, le fer ou le palladium.

A titre de variante, des structures halogénées de type, A₃B₂X₉ peuvent être utilisées, où B est compris dans la liste comprenant le bismuth (Bi) et l'antimoine (Sb).

A titre de variante, des structures halogénées de type, A₂BX₆ peuvent être utilisées, où B est compris dans la liste comprenant l'étain, le palladium et le titane.

Plus généralement, toute autre structure de matériau pérovskite adaptée peut être utilisée.

La figure 2 est une vue en coupe illustrant plus en détail un exemple de réalisation du dispositif de la figure 1.

Dans cet exemple, la couche active 105 de la LED 103 comprend, dans l'ordre à partir de la face supérieure de l'électrode inférieure 107, une première couche semiconductrice 105a dopée d'un premier type de conductivité, par exemple de type N, un empilement à puits quantiques multiples (non détaillés sur la figure) 105b, et une deuxième couche semiconductrice 105c dopée d'un second type de conductivité opposé au premier type de conductivité, par exemple de type P. La couche 105a est par exemple en contact, par sa face inférieure, avec la face supérieure de l'électrode 107, et, par sa face supérieure, avec la face inférieure de l'empilement à puits quantiques multiples 105b. La couche 105c est par exemple en contact, par sa face inférieure, avec la face supérieure de l'empilement à puits quantiques multiples 105b, et, par sa face supérieure, avec la face inférieure de l'électrode 109. Les couches 105a et 105b sont par exemple en un matériau semiconducteur III-V, par exemple nitrure de gallium. L'empilement à puits quantiques multiples 105b comprend par exemple une ou plusieurs couches émissives formant chacune un puits quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, l'empilement à puits quantiques multiples 105b peut être remplacé par une couche de nitrure de gallium intrinsèque, c'est-à-dire non intentionnellement dopé, par exemple de concentration en donneurs résiduels comprise entre 10^15 et 10^19 atomes/cm3, par exemple de l'ordre de 10^17 atomes/cm3.

Dans l'exemple de la figure 2, l'électrode inférieure 113 du photodétecteur 117 comprend une couche de transport de trous 113a en contact, par sa face supérieure, avec la face inférieure de la couche de conversion 111, et une couche conductrice 113b en contact, par sa face supérieure, avec la face inférieure de la couche 113a et, par sa face inférieure, avec la face supérieure de la couche de passivation 119.

Dans l'exemple de la figure 2, l'électrode supérieure 115 du photodétecteur 117 comprend une couche de transport d'électrons 115a en contact, par sa face inférieure, avec la face supérieure de la couche de conversion 111, et une couche conductrice 115b en contact, par sa face inférieure, avec la face supérieure de la couche 115a.

Dans le cas où la couche de conversion 111 est en un matériau pérovskite, par exemple en CsSnI₃, la couche de transports de trous 113a est par exemple en oxyde de nickel (NiO), et la couche de transport d'électrons 115a est par exemple en dioxyde de titane (TiO₂) ou en dioxyde d'étain (SnO₂). Les couches conductrices 113b et 115b sont par exemple en un oxyde conducteur transparent, par exemple en ITO. A titre de variante, la couche de transport de trous peut être en un matériau organique, par exemple de type Spiro-OMeTAD ou BCP (Bathocuproine). La couche de transport d'électrons peut être en un matériau organique, par exemple de type PCBM ([6,6]-phényl-C₆₁-butanoate de méthyle).

A titre d'exemple, le dispositif peut en outre comprendre une couche de passivation supérieure 201 disposée sur et en contact avec la face supérieure de l'électrode 115, c'est à dire sur et en contact avec la face supérieure de la couche conductrice 115b dans l'exemple représenté. La couche de passivation 201 est de préférence transparente dans la gamme de longueurs d'onde d'émission de la couche de conversion 111. A titre d'exemple, la couche de passivation supérieure 201 est en oxyde de silicium (SiO₂).

A titre d'exemple, le dispositif peut en outre comprendre un filtre optique 203 disposé au-dessus du photodétecteur 117, par exemple sur et en contact avec la face supérieure de la couche de passivation 201. Le filtre optique est par exemple un filtre passe-bande ou passe-haut adapté à laisser passer la lumière dans la gamme de longueur d'ondes d'émission de la couche de conversion 111, et à bloquer la lumière à d'autres longueurs d'ondes et en particulier dans la gamme d'émission de la LED 103. A titre d'exemple, le filtre optique 203 est adapté à laisser passer les rayonnements infrarouges et à bloquer les rayonnements visibles.

A titre d'exemple, le filtre optique 203 permet :
- en émission, d'éviter que des rayons résiduels émis par la LED 103 et non convertis par la couche de conversion 111 ne soient extraits du dispositif et projetés vers l'utilisateur ; et/ou
- en réception, de bloquer des rayonnements incidents situés en dehors de la gamme de longueurs d'onde d'intérêt que l'on cherche à mesurer, de façon à améliorer la sélectivité du photodétecteur 117.

Le filtre optique 203 est par exemple un filtre en résine ou un filtre interférentiel, par exemple constitué d'une alternance de couches diélectriques d'indices de réfractions différents.

Dans l'exemple de la figure 2, on a représenté schématiquement quatre vias conduteurs 205a, 205b, 205c, 205d en contact, par leurs faces inférieures, avec respectivement la face supérieure de l'électrode 107, la face supérieure de l'électrode 109, la face supérieure de la couche conductrice 113b de l'électrode 113, et la face supérieure de l'électrode 115b. Les vias conducteurs 205a, 205b, 205c, 205d sont par exemple métalliques. Dans l'exemple représenté, les vias conducteurs 205a, 205b, 205c, 205d sont entourés latéralement d'un matériau isolant 207, par exemple de l'oxyde de silicium.

Les vias conducteurs 205a, 205b, 205c, 205d permettent, dans cet exemple, de ramener du côté de la face supérieure du dispositif les contacts sur les électrodes 107, 109, 113 et 115. Les électrodes 107, 109, 113 et 115 peuvent ainsi être connectées, par l'intermédiaire des vias conducteurs 205a, 205b, 205c, 205d, à un circuit de contrôle configuré pour commander le dispositif en émission, en réception, ou alternativement en émission et en réception.

La figure 3 est une vue en coupe illustrant plus en détail un autre exemple de réalisation du dispositif de la figure 1.

L'exemple de la figure 3 diffère de celui de la figure 2 principalement en ce que, dans l'exemple de la figure 3, les vias conducteurs 205a, 205b, 205c et 205c de l'exemple de la figure 2 sont remplacés par quatre vias conduteurs 305a, 305b, 305c, 305d en contact, par leurs faces supérieures, avec respectivement la face inférieure de l'électrode 107, la face inférieure de l'électrode 109, la face inférieure de l'électrode 113, et la face inférieure de la couche conductrice 115b de l'électrode 115. Les vias conducteurs 305a, 305b, 305c, 305d sont par exemple métalliques. Dans l'exemple représenté, les vias conducteurs 305a, 30a5b, 305c, 305d sont entourés latéralement d'un matériau isolant 207, par exemple de l'oxyde de silicium. Dans cet exemple, l'électrode inférieure 107 de la LED 103 est séparée du substrat 101 par une couche électriquement isolante 309, par exemple en oxyde de silicium.

Les vias conducteurs 305a, 305b, 305c, 305d permettent, dans cet exemple, de ramener du côté de la face supérieure du substrat les contacts sur les électrodes 107, 109, 113 et 115. A titre d'exemple, les vias conducteurs 305a, 305b, 305c, 305d sont respectivement en contact, par leurs faces inférieures, avec des plots de connexion métalliques (non détaillés sur les figures) situés du côté de la face supérieure du substrat 101.

Le substrat 101 comprend par exemple un circuit électronique de contrôle, par exemple à base de transistors MOS, par exemple un circuit CMOS, adapté à commander le dispositif en émission, en réception, ou alternativement en émission et en réception.

Un dispositif émetteur et récepteur de lumière du type décrit en relation avec les figures 1, 2 et 3 peut avantageusement être intégré dans de nombreux dispositifs, par exemple dans un écran d'affichage émissif à LED de manière à réaliser un dispositif d'affichage interactif. Dans ce cas, le dispositif peut comprendre une pluralité de cellules élémentaires d'émission-réception de lumière infrarouge du type décrit en relation avec les figures 1 à 3, régulièrement distribuées au sein de la matrice de pixels du dispositif d'affichage.

A titre d'exemple, chaque pixel du dispositif d'affichage peut comprendre plusieurs cellules émissives à LED commandables individuellement adaptées à émettre respectivement de la lumière visible dans des gammes de longueurs d'ondes différentes, par exemple une première cellule adaptée à émettre majoritairement de la lumière rouge, une deuxième cellule adaptée à émettre majoritairement de la lumière verte, et une troisième cellule adaptée à émettre majoritairement de la lumière bleue. Chaque pixel peut en outre comprendre une cellule d'émission-réception de lumière infrarouge du type décrit en relation avec les figures 1 à 3.

Les cellules élémentaires d'émission-réception de lumière infrarouge peuvent être commandées individuellement. A titre d'exemple, certaines cellules sont commandées en émission et définissent une source de lumière infrarouge distribuée au sein de la matrice de pixels, et certaines cellules sont commandées en réception et forment un capteur infrarouge distribué au sein de la matrice de pixels.

La configuration des cellules élémentaires en émission et en réception peut par exemple être modifiée dynamiquement pour s'adapter à différentes situations d'utilisation du dispositif.

A titre de variante, la configuration des cellules élémentaires en émission et en réception reste fixe pour un dispositif d'affichage donné. Un avantage de la solution proposée est alors que les cellules d'émission et de réception sont structurellement identiques, ce qui permet de limiter les coûts de fabrication et de pouvoir adresser différentes applications avec un même dispositif, en modifiant seulement la configuration du circuit électronique de contrôle des cellules élémentaires d'émission-réception.

Le dispositif d'affichage émissif interactif est par exemple un dispositif monolithique, dans lequel tous les pixels et leurs circuits de contrôle sont intégrés de façon monolithique dans une même puce de circuits intégrés. A titre de variante, le dispositif d'affichage émissif interactif comprend une pluralité de micropuces discrêtes fixées et connectées électriquement à une même dalle d'interconnexion. A titre d'exemple, chaque micropuce correspond à un pixel du dispositif d'affichage et comprend, par exemple, trois cellules émissives à LED adaptées à émettre respectivement de la lumière rouge, de la lumière verte et de la lumière bleue, et une cellule d'émission-réception de lumière infrarouge.

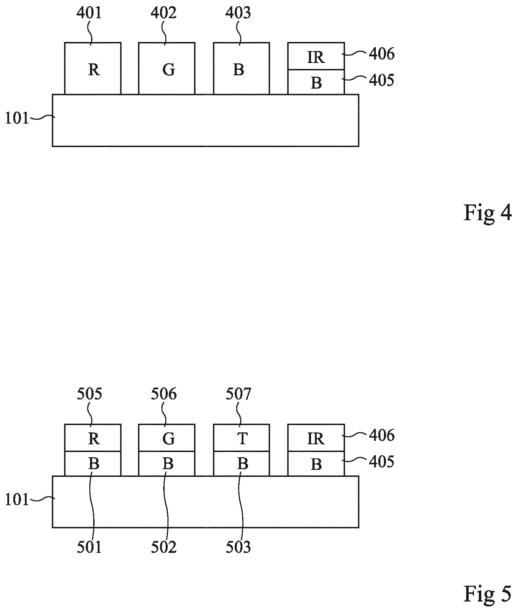

La figure 4 illustre de façon schématique un exemple de réalisation d'une telle micropuce de pixel.

Dans l'exemple de la figure 1, la micropuce de pixel comprend, sur un même substrat 101, trois LED 401, 402, 403 adaptées à émettre respectivement de la lumière rouge (R), de la lumière verte (G) et de la lumière bleue (B).

La micropuce comprend en outre une cellule d'émission-réception de lumière infrarouge du type décrit en relation avec les figures 1 à 3, comprenant, dans cet exemple, une LED 405 adaptée à émettre de la lumière bleue (B), et, superposée à la LED 405, un élément 406 adapté, en émission, à convertir la lumière émise par la LED 405 en un rayonnement infrarouge (IR) et, en réception, à mesurer l'intensité d'un rayonnement infrarouge incident.

Le substrat 101 comprend par exemple un circuit intégré de contrôle des LED visibles 401, 402, 403 et de la cellule d'émission-réception de lumière infrarouge 405, 406. Le circuit de contrôle est par exemple réalisé en technologie CMOS.

Pour chaque micropuce, la dalle de report comprend par exemple des plots métalliques de connexion destinés, lors du report, à être connectés électriquement à des plots de connexion métalliques correspondants de la micropuce, par exemple disposés du côté de la face du substrat 101 opposée aux LED.

La figure 5 illustre de façon schématique un autre exemple de réalisation d'une micropuce de pixel du type décrit ci-dessus.

Dans l'exemple de la figure 5, la micropuce de pixel comprend, sur un même substrat 101, trois LED 501, 502, 503, par exemple identiques aux dispersions de fabrication près, adaptées à émettre de la lumière dans une même gamme de longueur d'onde, par exemple de la lumière bleue (B).

La LED 501 est revêtue, du côté de sa face supérieure, par un élément de conversion photoluminescent 505 adapté à convertir la lumière émise par la LED 501 en lumière visible à une autre longueur d'onde, par exemple en lumière rouge (R).

La LED 502 est revêtue, du côté de sa face supérieure, par un élément de conversion photoluminescent 506 adapté à convertir la lumière émise par la LED 502 en lumière visible à une autre longueur d'onde, différente de la longueur d'onde d'émission de l'élément de conversion 505, par exemple en lumière verte (G).

La LED 503 est quant à elle revêtue, du côté de sa face supérieure, d'une couche 507 transparente (T) à la longueur d'onde d'émission de la LED 503.

Ainsi, dans cet exemple, la LED 501 et l'élément de conversion 505 définissent une première cellule émissive adaptée à émettre majoritairement de la lumière rouge, la LED 502 et l'élément de conversion 506 définissent une deuxième cellule émissive adaptée à émettre majoritairement de la lumière verte, et la LED 503 et la couche transparente définissent une troisième cellule émissive adaptées à émettre majoritairement de la lumière bleue.

Les éléments de conversion photoluminescents 505 et 506 sont par exemple en des matériaux pérovskites. Dans cet exemple, les éléments de conversion photoluminescents 505 et 506 ne sont pas contactés électriquement.

La micropuce comprend en outre, comme dans l'exemple de la figure 4, une cellule d'émission-réception de lumière infrarouge du type décrit en relation avec les figures 1 à 3, comprenant, dans cet exemple, une LED 405 adaptée à émettre de la lumière bleue (B), et, superposée à la LED 405, un élément 406 adapté, en émission, à convertir la lumière émise par la LED 405 en un rayonnement infrarouge (IR) et, en réception, à mesurer l'intensité d'un rayonnement infrarouge incident.

Le substrat 101 comprend par exemple un circuit intégré de contrôle des LED visibles 501, 502, 503 et de la cellule d'émission-réception de lumière infrarouge 405, 406. Le circuit de contrôle est par exemple réalisé en technologie CMOS.

On notera que dans les exemples des figures 4 et 5, chaque micropuce de pixel comprend trois cellules d'émission de lumière visible à LED et une cellule d'émission-réception de lumière infrarouge, disposées sur un même substrat de support intégrant un circuit de contrôle desdites cellules.

A titre de variante, chaque pixel peut comprendre plusieurs micropuces discrètes, par exemple quatre micropuces, par exemple une première micropuce comportant uniquement la cellule d'émission de lumière rouge 401/501-505 et son circuit de contrôle, une deuxième micropuce comportant uniquement la cellule d'émission de lumière verte 402/502-506 et son circuit de contrôle, une troisième micropuce comportant uniquement la cellule d'émission de lumière bleue 403/503-507 et son circuit de contrôle, et une quatrième micropuce comportant uniquement la cellule d'émission-réception de lumière infrarouge 405-506 et son circuit de contrôle. Autrement dit, dans les exemples des figures 4 et 5, les quatre cellules peuvent être singularisées par découpe du substrat 101 entre les cellules.

Dans une autre variante, les différentes cellules d'émission de lumière visible et d'émission-réception de lumière infrarouge peuvent être réalisées sous la forme de micropuces élémentaires n'intégrant pas de circuit de contrôle. Dans ces cas, les micropuces peuvent être reportée sur une dalle d'interconnexion intégrant des transistors de sélection réalisés, par exemple, en technologie TFT (de l'anglais « Thin Film Transistor » - transistor déposé en couches minces). Pour chaque puce, la dalle de report comprend des plots métalliques de connexion destinés, lors du report, à être connectés électriquement aux électrodes de la LED et, dans le cas des cellules d'émission-réception, aux électrodes du photodétecteur de la cellule.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'on ait décrit ci-dessus des exemples de réalisation dans lesquels la cellule d'émission réception de lumière est adaptée à émettre et détecter majoritairement de la lumière infrarouge, les modes de réalisation décrits ne se limitent pas à ce cas particulier. A titre de variante, l'élément de conversion 111 peut être choisi pour émettre et recevoir de la lumière dans une autre gamme de longueurs d'ondes, par exemple de la lumière visible.

En outre, les modes de réalisation décrits ne se limitent pas aux exemples décrits ci-dessus dans lesquels les cellules d'émission-réception sont intégrées de manière distribuées dans un dispositif d'affichage émissif à LED. A titre de variante, les cellules d'émission-réception décrites peuvent être intégrés dans d'autres types de dispositifs d'affichage, par exemple des dispositifs LCD, ou plus généralement, dans tout type de dispositif optoélectronique, par exemple des capteurs d'empreintes digitales ou tout autre type de capteur basé sur l'émission et la réception de rayonnement lumineux.

En outre, bien les matériaux pérovskites soient particulièrement avantageux pour la mise en oeuvre de la fonction de conversion de longueur d'onde et la fonction de photo-détection de la couche de conversion 111, les modes de réalisation décrits ne se limitent pas à ces matériaux. Plus généralement, la couche de conversion 111 peut être réalisée en tout autre matériau semiconducteur à gap direct présentant une bande interdite à la longueur d'onde de fonctionnement recherchée. Par exemple, la couche de conversion 111 peut comprendre des boîtes quantiques (quantum dots en anglais) noyés dans une couche ou matrice en un matériau polymère.

En outre, les modes de réalisation décrits ne se limitent pas aux exemples de matériaux et de dimensions mentionnés dans la description, notamment pour la réalisation des LED des cellules d'émission-réception décrites.

Enfin, la mise en oeuvre pratique des modes de réalisation et variantes décrits est à la portée de la personne du métier à partir des indications fonctionnelles données ci-dessus, en particulier, pour ce qui est de la réalisation des circuits électroniques de contrôle des cellules d'émission-réception décrites.

## Revendications

1. Dispositif émetteur et récepteur de lumière comportant :
- une diode électroluminescente (103 ; 405) comportant une première couche active (105), une première électrode (107) en contact avec la face inférieure de la première couche active (105), et une deuxième électrode (109) en contact avec la face supérieure de la première couche active (105) ; et
- en vis à vis de la diode électroluminescente (103 ; 405), sur une face d'émission de la diode électroluminescente (103 ;405), un élément de conversion et de détection de lumière (117 ; 406) comportant une deuxième couche active (111), une troisième électrode (113) en contact avec la face inférieure de la deuxième couche active (111), et une quatrième électrode (115) en contact avec la face supérieure de la deuxième couche active (111),
le dispositif comprenant en outre un circuit électronique de contrôle configuré pour, lors d'une phase d'émission, appliquer un courant dans la première couche active (105) par l'intermédiaire des première (107) et deuxième (109) électrodes, et maintenir les troisième (113) et quatrième (115) électrodes en circuit ouvert, ou, lors d'une phase de réception, maintenir les première (107) et deuxième (109) électrodes en circuit ouvert ou en court-circuit et mesurer, par l'intermédiaire des troisième (113) et quatrième (115) électrodes, un signal électrique représentatif d'un rayonnement lumineux absorbé par la deuxième couche active (111).

2. Dispositif selon la revendication 1, dans lequel la deuxième couche active (111) comprend un matériau photoluminescent adapté, lors de la phase d'émission, à absorber des photons dans la gamme de longueurs d'ondes d'émission de la diode électroluminescente (103 ; 405), et, en réponse à réémettre des photons dans une autre gamme de longueur d'ondes, et, lors de la phase de réception, à générer un signal électrique représentatif d'un rayonnement lumineux absorbé.

3. Dispositif selon la revendication 2, dans lequel la diode électroluminescente (103 ; 405) est adaptée à émettre de la lumière visible, et dans lequel la deuxième couche active (111) est adaptée à émettre un rayonnement infrarouge.

4. Dispositif selon l'une quelconque des revendications 1 à 3, dans lequel la deuxième couche active (111) comprend une couche en un matériau pérovskite.

5. Dispositif selon la revendication 4, dans lequel ladite couche en un matériau pérovskite est en un matériau pérovskite inorganique.

6. Dispositif selon la revendication 4, dans lequel ladite couche en un matériau pérovskite est en CsSnI₃.

7. Dispositif selon l'une quelconque des revendications 1 à 6, dans lequel les deuxième et troisième électrodes sont transparentes dans la gamme de longueurs d'ondes d'émission de la diode électroluminescente (103 ; 405), et dans lequel la quatrième électrode est transparente dans la gamme de longueur d'onde d'émission de la deuxième couche active (111).

8. Dispositif selon l'une quelconque des revendications 1 à 7, dans lequel les deuxième (109) et troisième (113) électrodes sont isolées électriquement l'une de l'autre par une couche de passivation (119) transparente dans la gamme de longueurs d'ondes d'émission de la diode électroluminescente (103 ; 405).

9. Dispositif selon l'une quelconque des revendications 1 à 8, comprenant en outre, sur la face supérieure de l'élément de conversion et de détection de lumière (117 ; 406), un filtre optique (203) adapté à laisser passer les rayonnements lumineux dans la gamme de longueurs d'ondes d'émission de la deuxième couche active (111) et à bloquer les rayonnements lumineux dans la gamme de longueurs d'onde d'émission de la diode électroluminescente (103 ; 405).

10. Puce élémentaire de dispositif optoélectronique comprenant un dispositif émetteur et récepteur de lumière (405, 406) selon l'une quelconque des revendications 1 à 9.

11. Puce élémentaire selon la revendication 10, comportant en outre une ou plusieurs cellules émissives comportant chacune une diode électroluminescente (401, 402, 403 ; 501, 502, 503).

12. Dispositif optoélectronique comportant une pluralité de puces élémentaires selon la revendication 10 ou 11 fixées et connectées électriquement à une même dalle d'interconnexion.

13. Procédé de fabrication d'un dispositif selon la revendication 4, dans lequel le matériau pérovskite est déposé par dépôt laser pulsé.

## Patentansprüche

1. Licht emittierende und empfangende Vorrichtung, die Folgendes aufweist:
- eine Leuchtdiode (103; 405), die Folgendes aufweist: eine erste aktive Schicht (105), eine erste Elektrode (107), die mit der Unterseite der ersten aktiven Schicht (105) in Kontakt steht, und eine zweite Elektrode (109), die mit der Oberseite der ersten aktiven Schicht (105) in Kontakt steht; und
- gegenüber der Leuchtdiode (103; 405), und zwar auf einer Emissionsfläche der Leuchtdiode (103; 405), ein Lichtumwandlungs- und - detektionselement (117; 406), das Folgendes aufweist: eine zweite aktive Schicht (111), eine dritte Elektrode (113), die mit der Unterseite der zweiten aktiven Schicht (111) in Kontakt steht, und eine vierte Elektrode (115), die mit der Oberseite der zweiten aktiven Schicht (111) in Kontakt steht,
wobei die Vorrichtung ferner eine elektronische Steuerschaltung aufweist, die so konfiguriert ist, dass sie während einer Emissionsphase einen Strom über die erste (107) und zweite (109) Elektrode in die erste aktive Schicht (105) einspeist und dass sie die dritte (113) und die vierte (115) Elektrode offengeschaltet hält, oder dass sie, während einer Empfangsphase, die erste (107) und die zweite (109) Elektrode offengeschaltet oder kurzgeschlossen hält und dass sie, über die dritte (113) und vierte (115) Elektrode, ein elektrisches Signal misst, das für die von der zweiten aktiven Schicht (111) absorbierte Lichtstrahlung repräsentativ ist.

2. Die Vorrichtung nach Anspruch 1, wobei die zweite aktive Schicht (111) ein photoluminiszentes Material aufweist, das so ausgelegt ist, dass es während der Emissionsphase Photonen im Emissionswellenlängenbereich der Leuchtdiode (103; 405) absorbiert und, daraufhin, Photonen in einem anderen Wellenlängenbereich wieder emittiert und, während der Empfangsphase, ein elektrisches Signal erzeugt, das für eine absorbierte Lichtstrahlung repräsentativ ist.

3. Die Vorrichtung nach Anspruch 2, wobei die Leuchtdiode (103; 405) dazu ausgelegt ist, sichtbares Licht zu emittieren, und wobei die zweite aktive Schicht (111) dazu ausgelegt ist, Infrarotstrahlung zu emittieren.

4. Die Vorrichtung nach einem der Ansprüche 1 bis 3, wobei die zweite aktive Schicht (111) eine Schicht aus einem Perowskitmaterial aufweist.

5. Die Vorrichtung nach Anspruch 4, wobei die Schicht aus einem Perowskitmaterial aus einem anorganischen Perowskitmaterial besteht.

6. Die Vorrichtung nach Anspruch 4, wobei die Schicht aus einem Perowskitmaterial aus CsSnI₃ besteht.

7. Die Vorrichtung nach einem der Ansprüche 1 bis 6, wobei die zweite und die dritte Elektrode im Emissionswellenlängenbereich der Leuchtdiode (103; 405) transparent sind und wobei die vierte Elektrode im Emissionswellenlängenbereich der zweiten aktiven Schicht (111) transparent ist.

8. Die Vorrichtung nach einem der Ansprüche 1 bis 7, wobei die zweite (109) und die dritte (113) Elektrode durch eine Passivierungsschicht (119), die im Emissionswellenlängenbereich der Leuchtdiode (103; 405) transparent ist, elektrisch voneinander isoliert sind.

9. Die Vorrichtung nach einem der Ansprüche 1 bis 8, die ferner auf der Oberseite des Lichtumwandlungs- und -detektionselements (117; 406) ein optisches Filter (203) aufweist, das so ausgelegt ist, dass es Lichtstrahlung im Emissionswellenlängenbereich der zweiten aktiven Schicht (111) durchlässt und dass es Lichtstrahlung im Emissionswellenlängenbereich der Leuchtdiode (103; 405) blockiert.

10. Elementarchip einer optoelektronischen Vorrichtung, der eine lichtemittierende und lichtempfangende Vorrichtung (405, 406) nach einem der Ansprüche 1 bis 9 aufweist.

11. Der Elementarchip nach Anspruch 10, der ferner eine oder mehrere emittierende Zellen aufweist, die jeweils eine Leuchtdiode (401, 402, 403; 501, 502, 503) aufweisen.

12. Optoelektronisches Bauelement, das eine Vielzahl von Elementarchips nach Anspruch 10 oder 11 aufweist, die an einer einzigen Verbindungskachel befestigt und elektrisch mit dieser verbunden sind.

13. Ein Verfahren zur Herstellung eine Vorrichtung nach Anspruch 4, wobei das Perowskitmaterial durch gepulste Laserdeposition abgeschieden wird.

## Claims

1. Light emitting and receiving device comprising:
- a light-emitting diode (103; 405) comprising a first active layer (105), a first electrode (107) in contact with the lower face of the first active layer (105), and a second electrode (109) in contact with the upper face of the first active layer (105); and
- opposite the light-emitting diode (103; 405), on an emission face of the light-emitting diode (103; 405), a light conversion and detection element (117; 406) comprising a second active layer (111), a third electrode (113) in contact with the lower face of the second active layer (111), and a fourth electrode (115) in contact with the upper face of the second active layer (111),
the device further comprising an electronic control circuit configured to, during an emission phase, apply a current in the first active layer (105) via the first (107) and second (109) electrodes, and keep the third (113) and fourth (115) electrodes open-circuited, or, during a reception phase, keep the first (107) and second (109) electrodes open-circuited or short-circuited and measure, via the third (113) and fourth (115) electrodes, an electrical signal representative of light radiation absorbed by the second active layer (111).

2. The device of claim 1, wherein the second active layer (111) comprises a photoluminescent material adapted to, during the emission phase, absorb photons in the emission wavelength range of the light-emitting diode (103; 405), and, in response, to re-emit photons in another wavelength range, and, during the reception phase, generate an electrical signal representative of an absorbed light radiation.

3. The device of claim 2, wherein the light-emitting diode (103; 405) is adapted to emit visible light and wherein the second active layer (111) is adapted to emit infrared radiation.

4. The device according to any one of claims 1 to 3, wherein the second active layer (111) comprises a layer of a perovskite material.

5. The device of claim 4, wherein said layer of a perovskite material is made of an inorganic perovskite material.

6. The device of claim 4, wherein said layer of a perovskite material is made of CsSnI₃.

7. The device according to any one of claims 1 to 6, wherein the second and third electrodes are transparent in the emission wavelength range of the light-emitting diode (103; 405), and wherein the fourth electrode is transparent in the emission wavelength range of the second active layer (111).

8. The device according to any one of claims 1 to 7, wherein the second (109) and third (113) electrodes are electrically insulated from each other by a passivation layer (119) transparent in the emission wavelength range of the light-emitting diode (103; 405).

9. The device according to any one of claims 1 to 8, further comprising, on the upper face of the light conversion and detection element (117; 406), an optical filter (203) adapted to pass light radiation in the emission wavelength range of the second active layer (111) and to block light radiation in the emission wavelength range of the light-emitting diode (103; 405).

10. Elementary chip of an optoelectronic device comprising a light-emitting and light-receiving device (405, 406) according to any one of claims 1 to 9.

11. The elementary chip of claim 10, further comprising one or more emissive cells each comprising a light-emitting diode (401, 402, 403; 501, 502, 503).

12. Optoelectronic device comprising a plurality of elementary chips according to claim 10 or 11 fixed and electrically connected to a single interconnection tile.

13. A method of manufacturing a device according to claim 4, wherein the perovskite material is deposited by pulsed laser deposition.
